# EUROPEAN PATENT APPLICATION

(11) **EP 4 636 489 A1**
(43) Date of publication of application: **22.10.2025**
(21) Application number: 23911905.0
(22) Date of filing: 20.12.2023
(51) Int. Cl.: G03F 7/26, G03F 7/004, H01L 21/027, H01L 21/3065

(54) **SUBSTRATE PROCESSING METHOD AND SUBSTRATE PROCESSING DEVICE**

(30) Priority: 28.12.2022 JP 2022211966
(71) Applicant: Tokyo Electron Limited, Tokyo 107-6325 (JP)
(72) Inventor: NAKANE, Yuta, Kurokawa-gun, Miyagi 981-3629 (JP); KUMAKURA, Sho, Kurokawa-gun, Miyagi 981-3629 (JP)
(74) Representative: Piotrowicz, Pawel Jan Andrzej
(86) International application number: PCT/JP2023/045771
(87) International publication number: WO 2024/143125

(57) **Abstract**

In one exemplary embodiment, a substrate processing method includes (a) providing a substrate on a substrate support in a chamber, the substrate including an etching target film and a metal-containing resist on the etching target film, the metal-containing resist including a first region exposed to EUV light and a second region not exposed to the EUV light, (b) removing the second region by dry development using a development gas, (cl) generating a second metal-containing substance from a first metal-containing substance using a fluorine-containing gas after the (b), the second metal-containing substance including a metal fluoride, and (c2) generating a third metal-containing substance from the second metal-containing substance and removing the third metal-containing substance by heating the chamber or a component and supplying a processing gas into the chamber.

## Description

### Technical Field

Exemplary embodiments of the present disclosure relate to a substrate processing method and a substrate processing apparatus.

### Background Art

Patent Literature 1 discloses a method of etching a laminated film of an aluminum film and a titanium nitride film and generating plasma from a mixed gas of boron trichloride and chlorine to clean the laminated film.

### Citation List

### Patent Literature

[Patent Literature 1] Japanese Unexamined Patent Publication No. 2000-12515

### Summary of Invention

### Technical Problem

The present disclosure provides a substrate processing method and a substrate processing apparatus capable of suppressing damage to a chamber or a component.

### Solution to Problem

In one exemplary embodiment, a substrate processing method includes (a) providing a substrate on a substrate support in a chamber, the substrate including an etching target film and a metal-containing resist on the etching target film, the metal-containing resist including a first region exposed to EUV light and a second region not exposed to the EUV light, (b) removing the second region by dry development using a development gas, and (c) removing a first metal-containing substance adhered to the chamber or a component disposed in the chamber after the (b), in which the (c) includes (c1) generating a second metal-containing substance from the first metal-containing substance using a fluorine-containing gas, the second metal-containing substance including a metal fluoride, and (c2) generating a third metal-containing substance from the second metal-containing substance and removing the third metal-containing substance by heating the chamber or the component and supplying a processing gas into the chamber.

### Advantageous Effects of Invention

According to one exemplary embodiment, a technique is provided that can suppress damage to a chamber or a component.

### Brief Description of Drawings

FIG. 1 is a schematic diagram showing the substrate processing apparatus according to an exemplary embodiment.
FIG. 2 is a schematic diagram showing a substrate processing apparatus according to another exemplary embodiment.
FIG. 3 is a schematic diagram showing a substrate processing apparatus according to still another exemplary embodiment.
FIG. 4 is a schematic diagram showing a substrate processing apparatus according to still another exemplary embodiment.
FIG. 5 is a flowchart of a substrate processing method according to one exemplary embodiment.
FIG. 6 is a cross-sectional view of an example of a substrate to which the method in FIG. 5 may be applied.
FIG. 7 is a cross-sectional view showing a step of a dry development method according to one exemplary embodiment.
FIG. 8 is a partially enlarged cross-sectional view of an example of a substrate processing apparatus after the development step.
FIG. 9 is a partially enlarged cross-sectional view of an example of a substrate processing apparatus in a step of forming a second metal-containing substance.
FIG. 10 is a partially enlarged cross-sectional view of an example of a substrate processing apparatus in a step of forming and removing a third metal-containing substance.
FIG. 11 is a flowchart of a substrate processing method according to a modification example.

### Description of Embodiments

Hereinafter, various exemplary embodiments will be described in detail with reference to the drawings. In the drawing, the same or equivalent portions are denoted by the same reference signs.

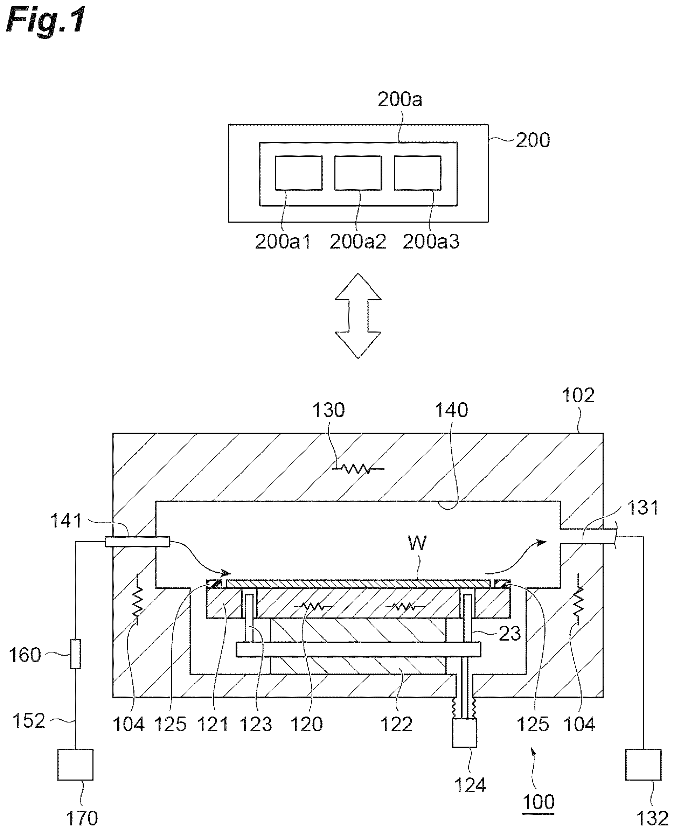

FIG. 1 is a diagram for describing a configuration example of a heat treatment system. In one exemplary embodiment, a heat treatment system includes a heat treatment apparatus 100 and a controller 200. The heat treatment system is an example of a system for processing a substrate. The heat treatment apparatus 100 is an example of a substrate processing apparatus.

The heat treatment apparatus 100 has a processing chamber 102 (chamber) that is configured to be sealable. The processing chamber 102 is, for example, an airtight cylindrical container, and is configured to be able to control the atmosphere inside. A side wall heater 104 is provided on a side wall of the processing chamber 102. A ceiling heater 130 is provided on a ceiling wall (top plate) of the processing chamber 102. A ceiling surface 140 of a ceiling wall (top plate) of the processing chamber 102 is formed as a horizontal flat surface, for example. A temperature of the ceiling surface 140 is controlled by the ceiling heater 130.

A substrate support 121 is provided on a lower side in the processing chamber 102. The substrate support 121 constitutes a placing portion on which a substrate W is placed. The substrate support 121 may have, for example, a circular surface (upper surface) or may have a surface (upper surface) formed horizontally. The substrate W is placed on a surface of the substrate support 121. A stage heater 120 is embedded in the substrate support 121. The stage heater 120 can heat the substrate W placed on the substrate support 121. A ring assembly 125 may be disposed on the substrate support 121 to surround the substrate W. The ring assembly 125 may include one or a plurality of annular members. By disposing the ring assembly 125, it is possible to improve the temperature controllability of an outer peripheral region of the substrate W. The ring assembly 125 may be made of inorganic materials or organic materials depending on the desired heat treatment.

The substrate support 121 is supported in the processing chamber 102 by a column 122 provided on a bottom surface of the processing chamber 102. A plurality of lift pins 123 that, for example, vertically move are provided on an outer side of the column 122 in a circumferential direction. The plurality of lift pins 123 are each inserted into a plurality of through-holes provided at intervals in the circumferential direction of the substrate support 121. The lifting operation of the lift pin 123 is controlled by a lift mechanism 124. In a case where the lift pin 123 protrudes from the surface of the substrate support 121, the substrate W is delivered between a transport mechanism (not shown) and the substrate support 121.

An exhaust port 131 having an opening is provided on a side wall of the processing chamber 102. The exhaust port 131 is connected to an exhaust mechanism 132 via an exhaust pipe. The exhaust mechanism 132 is made of a vacuum pump, a valve, and the like, and adjusts an exhaust flow rate from the exhaust port 131. The pressure in the processing chamber 102 is adjusted by adjusting the exhaust flow rate and the like by means of the exhaust mechanism 132. A transport port (not shown) of the substrate W is formed to be openable and closable, on a side wall of the processing chamber 102 at a position different from a position of the exhaust port 131.

In addition, a gas nozzle 141 is provided at a position different from the positions of the exhaust port 131 and the transport port of the substrate W on the side wall of the processing chamber 102. The gas nozzle 141 supplies the processing gas into the processing chamber 102. The gas nozzle 141 is provided on a side opposite to the exhaust port 131 as viewed from a central portion of the substrate support 121, on the side wall of the processing chamber 102.

The gas nozzle 141 is formed in a rod shape that protrudes from the side wall of the processing chamber 102 toward the center side of the processing chamber 102. A distal end of the gas nozzle 141 extends, for example, horizontally from the side wall of the processing chamber 102. The processing gas is discharged into the processing chamber 102 from a discharge port provided at the distal end of the gas nozzle 141. The discharged processing gas flows in a direction of an arrow shown in FIG. 1 and is discharged from the exhaust port 131. The distal end of the gas nozzle 141 may extend obliquely downward toward the substrate W, or may extend obliquely upward toward the ceiling surface 140 of the processing chamber 102.

The gas nozzle 141 may be provided, for example, on the ceiling wall of the processing chamber 102. The exhaust port 131 may be provided on the bottom surface of the processing chamber 102.

The heat treatment apparatus 100 has a gas supply pipe 152 connected to the gas nozzle 141 from the outer side of the processing chamber 102. A pipe heater 160 for heating an inside of the gas supply pipe 152 is provided around the gas supply pipe 152. The gas supply pipe 152 is connected to a gas supply 170. The gas supply 170 includes at least one gas source and at least one flow rate control device. The gas supply may include a vaporizer that vaporizes a gas source in a liquid state.

The controller 200 processes computer-executable instructions for causing the heat treatment apparatus 100 to execute various steps described in the present disclosure. The controller 200 may be configured to control each element of the heat treatment apparatus 100 to execute various steps described herein. In one embodiment, a part or all of the controller 200 may be included in the heat treatment apparatus 100. The controller 200 may include a processor 200a1, a storage 200a2, and a communication interface 200a3. The controller 200 is realized by, for example, a computer 200a. The processor 200a1 can be configured to read out a program from the storage 200a2 and execute the read out program to perform various control operations. This program may be stored in the storage 200a2 in advance, or may be acquired via the medium when necessary. The acquired program is stored in the storage 200a2, and is read out from the storage 200a2 and executed by the processor 200a1. The medium may be various storage media readable by the computer 200a, or may be a communication line connected to the communication interface 200a3. The processor 200a1 may be a central processing unit (CPU). The storage 200a2 may include a random access memory (RAM), a read only memory (ROM), a hard disk drive (HDD), a solid state drive (SSD), or combinations thereof. The communication interface 200a3 may be communicated with the heat treatment apparatus 100 via a communication line such as a local area network (LAN).

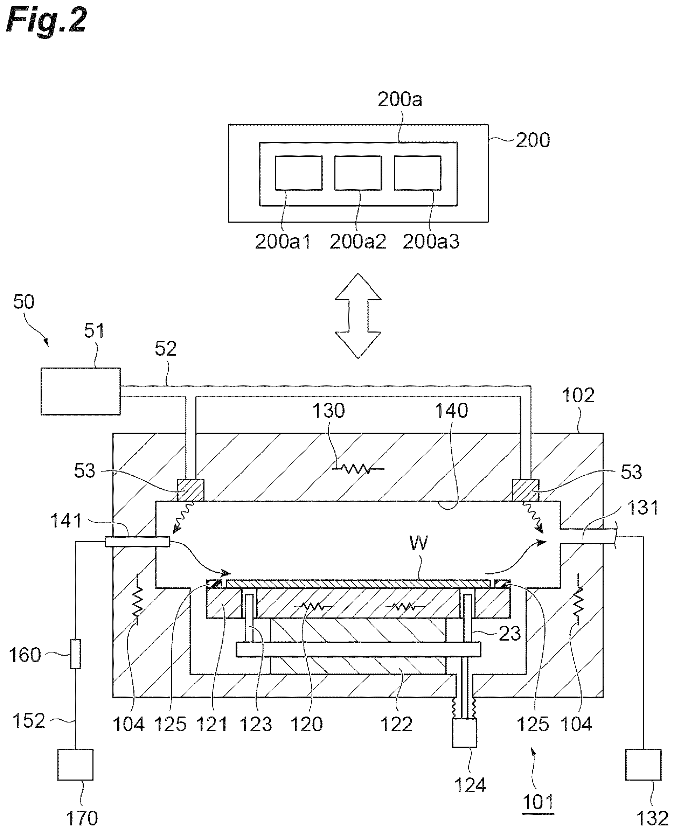

FIG. 2 is a schematic diagram showing a substrate processing apparatus according to another exemplary embodiment. A heat treatment apparatus 101 shown in FIG. 2 further includes a microwave heating device 50 in addition to the configuration of the heat treatment apparatus 100 shown in FIG. 1. The microwave heating device 50 can heat the processing chamber 102 or a component (for example, the substrate support 121 and the ring assembly 125) disposed in the processing chamber 102.

The microwave heating device 50 may include a microwave generator 51, a waveguide 52, and a quartz window 53. The microwave generator 51 is provided outside the processing chamber 102, for example, above the processing chamber 102. The microwave generator 51 includes a magnetron and generates a microwave. A frequency of the microwave is, for example, 2.45 GHz or 5.85 GHz. One end of the waveguide 52 is connected to the microwave generator 51. The other end of the waveguide 52 is connected to the quartz window 53. The quartz window 53 has a first surface connected to the waveguide 52 of the quartz window 53 and a second surface on a side opposite to the first surface. The quartz window 53 is provided such that the second surface is flush with the ceiling surface 140 of the processing chamber 102. The microwaves generated in the microwave generator 51 are emitted toward the processing chamber 102 or the substrate support 121 through the waveguide 52 and the quartz window 53. As a result, an inner surface of the processing chamber 102 or a surface of the substrate support 121 is heated. The irradiation direction of the microwave can be adjusted by positions or orientations of the waveguide 52 and the quartz window 53.

The microwave heating device 50 may heat the processing chamber 102 or the substrate support 121 by generating electromagnetic waves (for example, infrared rays) different from the microwaves. The microwave heating device 50 may include an infrared lamp. The heat treatment apparatus 101 may include at least one of the side wall heater 104, the stage heater 120, the ceiling heater 130, and the pipe heater 160. Alternatively, the heat treatment apparatus 101 may not include these heaters.

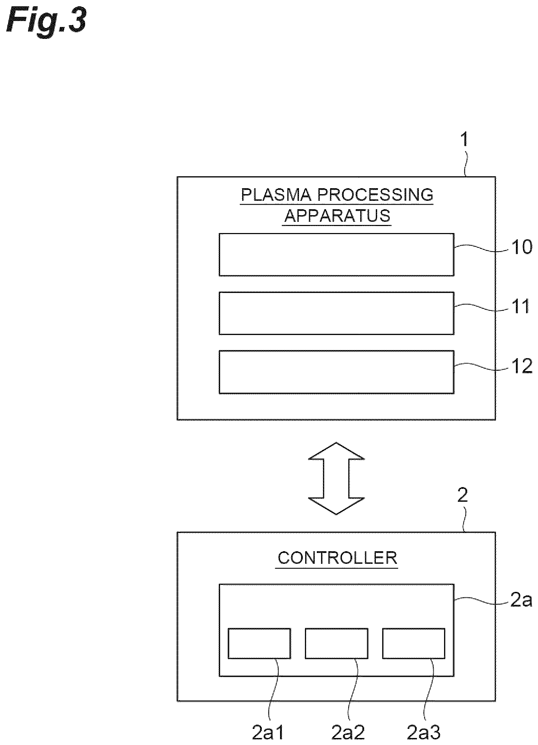

FIG. 3 is a diagram for describing a configuration example in a case where the plasma processing system is used as the development processing system. In one embodiment, a plasma processing system includes a plasma processing apparatus 1 and a controller 2. The plasma processing system is an example of a system for processing a substrate, and the plasma processing apparatus 1 is an example of a substrate processing apparatus. The plasma processing apparatus 1 includes a plasma processing chamber (hereinafter, also simply referred to as a "processing chamber") 10, a substrate support 11, and a plasma generator 12. The plasma processing chamber 10 has a plasma processing space. In addition, the plasma processing chamber 10 has at least one gas supply port for supplying at least one processing gas into the plasma processing space and at least one gas exhaust port for exhausting gases from the plasma processing space. The gas supply port is connected to a gas supply 20 described below and the gas exhaust port is connected to an exhaust system 40 described below. The substrate support 11 is disposed in the plasma processing space and has a substrate supporting surface for supporting the substrate.

The plasma generator 12 is configured to generate plasma from at least one processing gas supplied into the plasma processing space. The plasma formed in the plasma processing space may be a capacitively coupled plasma (CCP), an inductively coupled plasma (ICP), an electron-cyclotron-resonance (ECR) plasma, a helicon wave plasma (HWP), or a surface wave plasma (SWP), or the like. In addition, various types of plasma generators including an alternating current (AC) plasma generator and a direct current (DC) plasma generator may be used. In one embodiment, an AC signal (AC power) used in the AC plasma generator has a frequency in a range of 100 kHz to 10 GHz. Therefore, the AC signal includes a radio frequency (RF) signal and a microwave signal. In one embodiment, the RF signal has a frequency in a range of 100 kHz to 150 MHz.

The controller 2 processes computer-executable instructions for causing the plasma processing apparatus 1 to execute various steps described in the present disclosure. The controller 2 may be configured to control each element of the plasma processing apparatus 1 to execute various steps described herein. In one embodiment, the functions of the controller 2 may be partially or entirely incorporated into the plasma processing apparatus 1. The controller 2 is realized by, for example, a computer 2a. The controller 2 may include a processor 2a1, a storage 2a2, and a communication interface 2a3. Each configuration of the controller 2 may be the same as each configuration of the controller 200 described above (see FIG. 1).

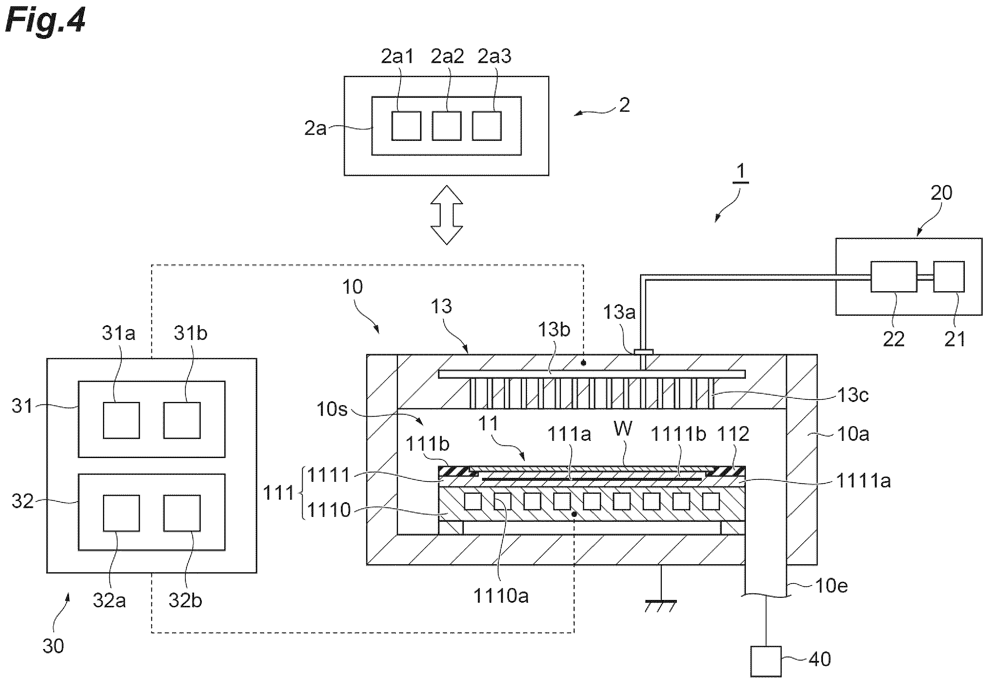

In the following, a configuration example of a capacitively coupled plasma processing apparatus, which is an example of the plasma processing apparatus 1, will be described. FIG. 4 is a diagram for describing a configuration example of a capacitively coupled plasma processing apparatus.

The capacitively coupled plasma processing apparatus 1 includes the plasma processing chamber 10, the gas supply 20, a power supply 30, and an exhaust system 40. In addition, the plasma processing apparatus 1 includes a substrate support 11 and a gas introduction unit. The gas introduction unit is configured to introduce at least one processing gas into the plasma processing chamber 10. The gas introduction unit includes a shower head 13. The substrate support 11 is disposed in the plasma processing chamber 10. The shower head 13 is disposed above the substrate support 11. In one embodiment, the shower head 13 constitutes at least a part of the ceiling of the plasma processing chamber 10. The plasma processing chamber 10 has a plasma processing space 10s that is defined by the shower head 13, a side wall 10a of the plasma processing chamber 10, and the substrate support 11. The plasma processing chamber 10 is grounded. The shower head 13 and the substrate support 11 are electrically insulated from a housing of the plasma processing chamber 10.

The substrate support 11 includes a body 111 and a ring assembly 112. The body 111 has a central region 111a for supporting the substrate W and an annular region 111b for supporting the ring assembly 112. A wafer is an example of the substrate W. The annular region 111b of the body 111 surrounds the central region 111a of the body 111 in a plan view. The substrate W is disposed on the central region 111a of the body 111, and the ring assembly 112 is disposed on the annular region 111b of the body 111 to surround the substrate W on the central region 111a of the body 111. Thus, the central region 111a is also referred to as a substrate supporting surface for supporting the substrate W, while the annular region 111b is also referred to as a ring supporting surface for supporting the ring assembly 112.

In one embodiment, the body 111 includes a base 1110 and an electrostatic chuck 1111. The base 1110 includes a conductive member. The conductive member of the base 1110 can function as a lower electrode. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has the central region 111a. In one embodiment, the ceramic member 1111a also has the annular region 111b. In addition, other members surrounding the electrostatic chuck 1111, such as an annular electrostatic chuck or an annular insulating member, may have the annular region 111b. In this case, the ring assembly 112 may be disposed on the annular electrostatic chuck or the annular insulating member, or may be disposed on both the electrostatic chuck 1111 and the annular insulating member. In addition, at least one RF/DC electrode coupled to an RF power supply 31 and/or a DC power supply 32 described below may be disposed in the ceramic member 1111a. In this case, at least one RF/DC electrode functions as the lower electrode. In a case where a bias RF signal and/or a DC signal described below is supplied to at least one RF/DC electrode, the RF/DC electrode is also referred to as a bias electrode. The conductive member of the base 1110 and at least one RF/DC electrode may function as a plurality of lower electrodes. In addition, the electrostatic electrode 1111b may function as the lower electrode. Therefore, the substrate support 11 includes at least one lower electrode.

The ring assembly 112 includes one or a plurality of annular members. In one embodiment, the one or plurality of annular members include one or a plurality of edge rings and at least one cover ring. The edge ring is formed of a conductive material or an insulating material, and the cover ring is formed of an insulating material.

In addition, the substrate support 11 may include a temperature adjusting module that is configured to adjust at least one of the electrostatic chuck 1111, the ring assembly 112, and the substrate to a target temperature. The temperature adjusting module may include a heater, a heat transfer medium, a flow path 1110a, or any combination thereof. A heat transfer fluid, such as brine or gas, flows into the flow path 1110a. In one embodiment, the flow path 1110a is formed in the base 1110, and one or a plurality of heaters are disposed in the ceramic member 1111a of the electrostatic chuck 1111. In addition, the substrate support 11 may further include a heat transfer gas supply configured to supply a heat transfer gas to a gap between a back surface of the substrate W and the central region 111a.

The shower head 13 is configured to introduce at least one processing gas from the gas supply 20 into the plasma processing space 10s. The shower head 13 has at least one gas supply port 13a, at least one gas diffusion chamber 13b, and a plurality of gas introduction ports 13c. The processing gas supplied to the gas supply port 13a passes through the gas diffusion chamber 13b and is introduced into the plasma processing space 10s from the plurality of gas introduction ports 13c. In addition, the shower head 13 includes at least one upper electrode. The gas introduction unit may include one or a plurality of side gas injectors (SGI) attached to one or a plurality of openings formed in the side wall 10a, in addition to the shower head 13.

The gas supply 20 may include at least one gas source 21 and at least one flow rate control device 22. In one embodiment, the gas supply 20 is configured to supply at least one processing gas from the respective corresponding gas source 21 through the respective corresponding flow rate control device 22 to the shower head 13. Each flow rate control device 22 may include, for example, a mass flow controller or a pressure-controlled flow rate control device. Further, the gas supply 20 may include at least one flow rate modulation device that modulates or pulses the flow rate of at least one processing gas.

The power supply 30 includes the RF power supply 31, which is coupled to the plasma processing chamber 10 via at least one impedance matching circuit. The RF power supply 31 is configured to supply at least one RF signal (RF power) to at least one lower electrode and/or at least one upper electrode. As a result, plasma is formed from at least one processing gas supplied to the plasma processing space 10s. Therefore, the RF power supply 31 can function as at least a part of the plasma generator 12. In addition, by supplying the bias RF signal to at least one lower electrode, a bias potential is generated on the substrate W, and ion components in the formed plasma can be drawn into the substrate W.

In one embodiment, the RF power supply 31 includes a first RF generator 31a and a second RF generator 31b. The first RF generator 31a is configured to be coupled to at least one lower electrode and/or at least one upper electrode via at least one impedance matching circuit, and is configured to generate a source RF signal (source RF power) for plasma generation. In one embodiment, the source RF signal has a frequency in a range of 10 MHz to 150 MHz. In one embodiment, the first RF generator 31a may be configured to generate a plurality of source RF signals having different frequencies. The generated one or plurality of source RF signals are supplied to at least one lower electrode and/or at least one upper electrode.

The second RF generator 31b is configured to be coupled to at least one lower electrode via at least one impedance matching circuit and is configured to generate a bias RF signal (bias RF power). The frequency of the bias RF signal may be the same as or different from the frequency of the source RF signal. In one embodiment, the bias RF signal has a frequency lower than the frequency of the source RF signal. In one embodiment, the bias RF signal has a frequency in a range of 100 kHz to 60 MHz. In one embodiment, the second RF generator 31b may be configured to generate a plurality of bias RF signals having different frequencies. The generated one or plurality of bias RF signals are supplied to at least one lower electrode. In addition, in various embodiments, at least one of the source RF signal and the bias RF signal may be pulsed.

In addition, the power supply 30 may include the DC power supply 32 coupled to the plasma processing chamber 10. The DC power supply 32 includes a first DC generator 32a and a second DC generator 32b. In one embodiment, the first DC generator 32a is configured to be connected to at least one lower electrode and is configured to generate a first DC signal. The generated first DC signal is applied to at least one lower electrode. In one embodiment, the second DC generator 32b is configured to be connected to at least one upper electrode and is configured to generate a second DC signal. The generated second DC signal is applied to at least one upper electrode.

In various embodiments, the first and second DC signals may be pulsed. In this case, a sequence of the voltage pulses is applied to at least one lower electrode and/or at least one upper electrode. The voltage pulse may have a pulse waveform of a rectangular, trapezoidal, triangular, or a combination thereof. In one embodiment, a waveform generator for generating the sequence of voltage pulses from the DC signal is connected between the first DC generator 32a and at least one lower electrode. Therefore, the first DC generator 32a and the waveform generator constitute a voltage pulse generator. In a case where the second DC generator 32b and the waveform generator constitute the voltage pulse generator, the voltage pulse generator is connected to at least one upper electrode. The voltage pulse may have a positive polarity or may have a negative polarity. Further, the sequence of the voltage pulses may include one or a plurality of positive-polarity voltage pulses and one or a plurality of negative-polarity voltage pulses in one cycle. The first and second DC generators 32a and 32b may be provided in addition to the RF power supply 31, or the first DC generator 32a may be provided instead of the second RF generator 31b.

The exhaust system 40 may be connected to, for example, a gas exhaust port 10e provided in a bottom of the plasma processing chamber 10. The exhaust system 40 may include a pressure regulating valve and a vacuum pump. The pressure in the plasma processing space 10s is adjusted by the pressure regulating valve. The vacuum pump may include a turbo molecular pump, a dry pump, or a combination thereof.

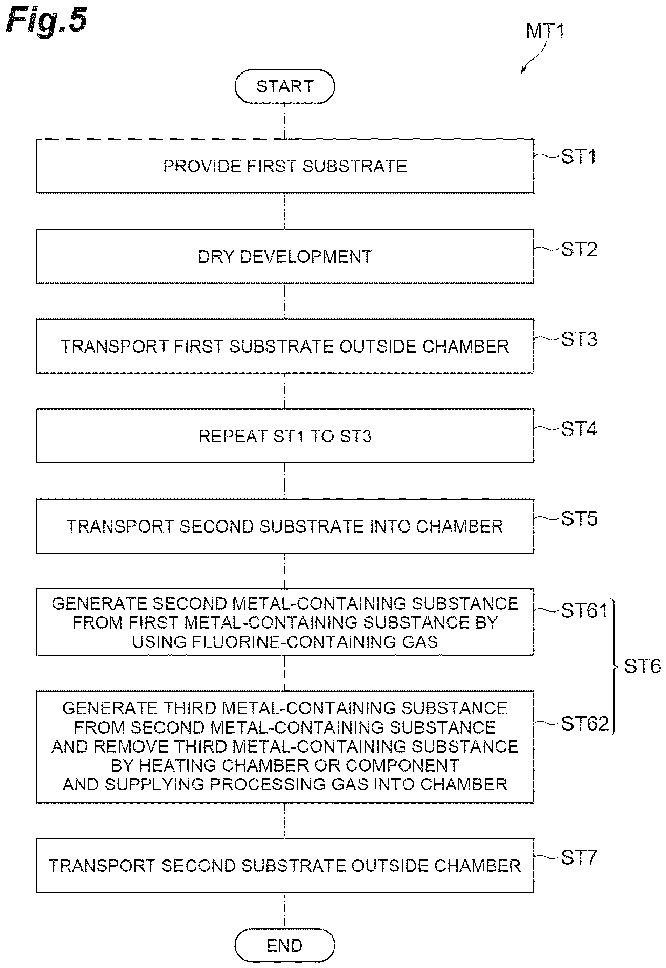

FIG. 5 is a flowchart of a substrate processing method (hereinafter, referred to as a "method MT1") according to one exemplary embodiment. The method MT1 may include Step ST1 to Step ST7. Step ST1 to Step ST7 may be executed in order. The method MT1 may not include Step ST3 to Step ST5 and Step ST7.

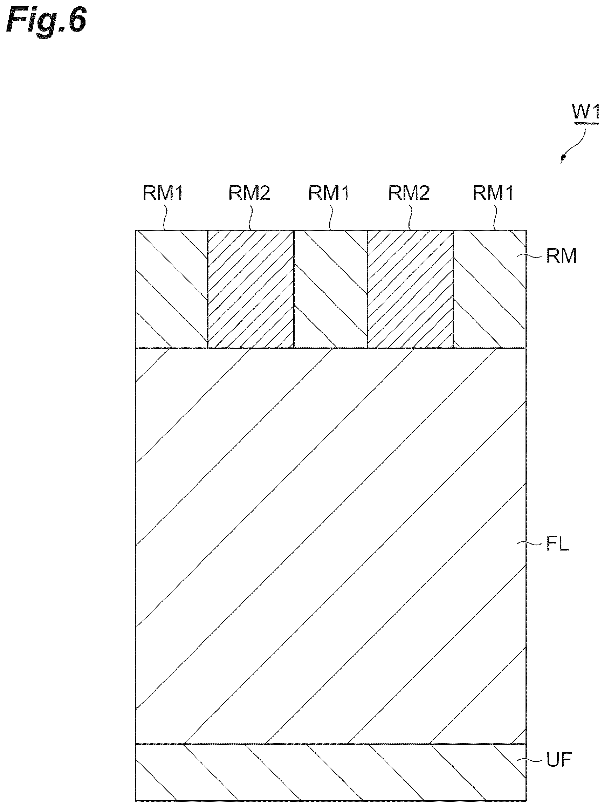

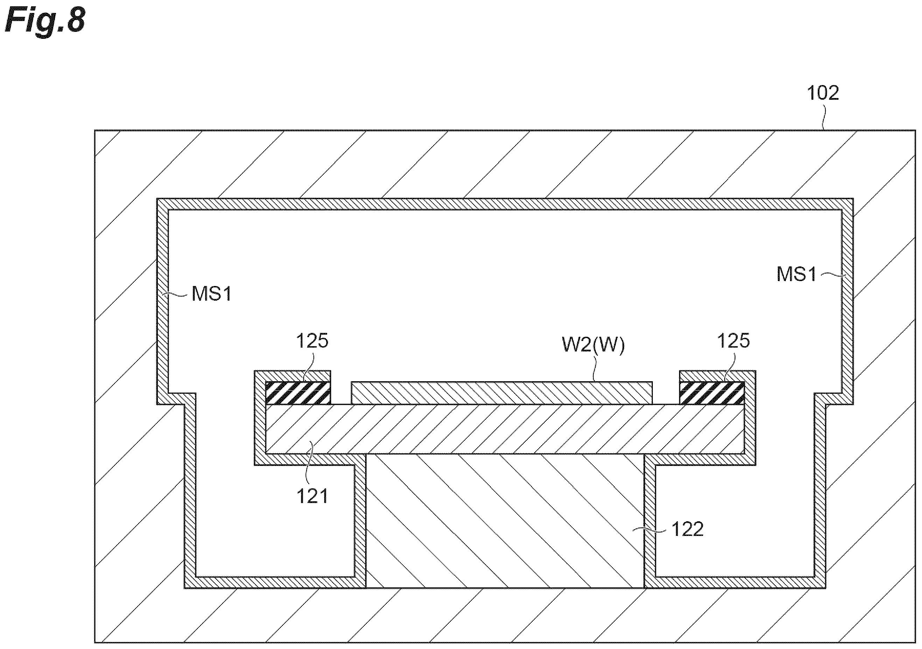

The method MT1 may be executed by using any one of the systems for processing a substrate described above (see FIGS. 1 to 4), or may be executed by using two or more of these systems for processing a substrate. For example, the method MT1 may be executed using the heat treatment system (see FIG. 1 or FIG. 2). In the following, a case where the controller 200 controls each unit of the heat treatment apparatus 100 or the heat treatment apparatus 101 to execute the method MT1 on a first substrate W1 (see FIG. 6) and a second substrate W2 (see FIG. 8) will be described as an example.

FIG. 6 is a view showing an example of a cross-sectional structure of the first substrate W1 provided in Step ST1. The first substrate W1 includes an underlying film UF, an etching target film FL formed on the underlying film UF, and a metal-containing resist RM. The first substrate W1 may be used for manufacturing a semiconductor device. The semiconductor device includes, for example, a semiconductor memory device such as a DRAM or a 3D-NAND flash memory. The etching target film FL may be, for example, a spin-on-glass (SOG) film or a spin-on-carbon (SOC) film.

The metal-containing resist RM may be a resist film containing a metal. The metal-containing resist RM may contain at least one selected from the group consisting of tin (Sn), hafnium (Hf), and titanium (Ti). The metal-containing resist RM may contain, for example, at least one selected from the group consisting of tin oxide, hafnium oxide, and titanium oxide, or may contain an organic substance.

The metal-containing resist RM has a first region RM1 exposed to EUV light and a second region RM2 not exposed to the EUV light.

### (Step ST1)

First, in Step ST1, as shown in FIG. 1 or FIG. 2, the first substrate W1 as the substrate W is provided in the processing chamber 102 of the heat treatment apparatus 100. The first substrate W1 may be transported into the processing chamber 102. The first substrate W1 is provided on the substrate support 121 via a lift pin 23. After the first substrate W1 is disposed on the substrate support 121, the temperature of the substrate support 121 is adjusted to a set temperature. The temperature of the substrate support 121 may be adjusted by controlling the output of one or more of the side wall heater 104, the stage heater 120, the ceiling heater 130, and the pipe heater 160 (hereinafter, these heaters are also collectively referred to as a "heater group"). In the method MT1, the temperature of the substrate support 121 may be adjusted to the set temperature before the Step ST1. That is, after the temperature of the substrate support 121 is adjusted to the set temperature, the first substrate W1 may be provided on the substrate support 121.

### (Step ST2)

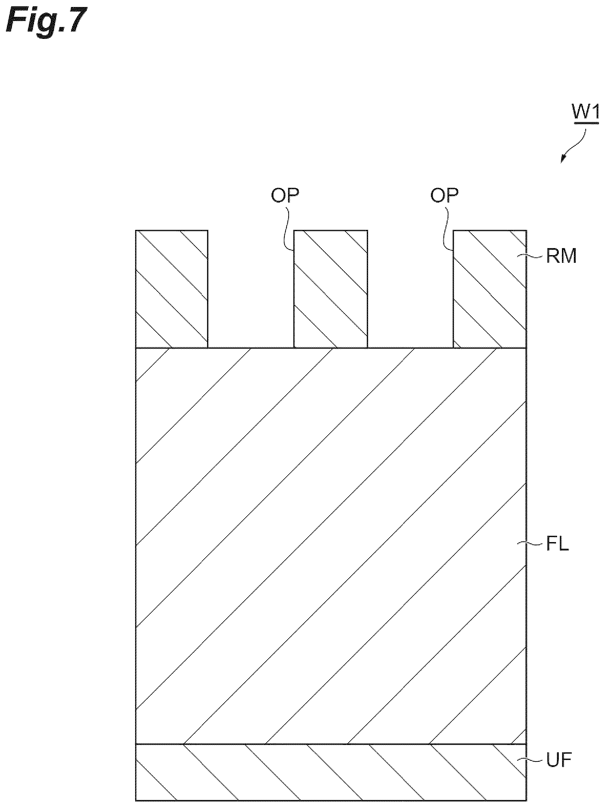

Subsequently, in Step ST2, as shown in FIG. 7, the second region RM2 is removed by dry development using a development gas. Specifically, by exposing the first substrate W1 to the development gas, the second region RM2 of the first substrate W1 is selectively removed, and the metal-containing resist RM is developed. The development gas is supplied into the processing chamber 102 by the gas supply 170. The supply of the development gas can be stopped at the end of Step ST2. In Step ST2, the first substrate W1 may be heated.

In Step ST2, at least one development gas is supplied to the first substrate W1. The development gas may contain at least one selected from the group consisting of hydrogen bromide (HBr), hydrogen fluoride (HF), hydrogen chloride (HCl), boron trichloride (BCl₃), an organic acid (for example, a carboxylic acid or an alcohol), and a β-dicarbonyl compound. The carboxylic acid in the development gas may include at least one selected from the group consisting of formic acid (HCOOH), acetic acid (CH₃COOH), trichloroacetic acid (CCl₃COOH), monofluoroacetic acid (CFH₂COOH), difluoroacetic acid (CF₂FCOOH), trifluoroacetic acid (CF₃COOH), chloro-difluoroacetic acid (CClF₂COOH), sulfur-containing acetic acid, thioacetic acid (CH₃COSH), thioglycolic acid (HSCH₂COOH), trifluoroacetic acid anhydride ((CF₃CO)₂O), and acetic acid anhydride ((CH₃CO)₂O). The alcohol in the development gas may include, for example, nonafluoro-tert-butyl alcohol ((CF₃)₃COH). The β-dicarbonyl compound in the development gas may be, for example, acetylacetone (CH₃C(O)CH₂C(O)CH₃), trichloroacetylacetone (CCl₃C(O)CH₂C(O)CH₃), hexachloroacetylacetone (CCl₃C(O)CH₂C(O)CCl₃), trifluoroacetylacetone (CF₃C(O)CH₂C(O)CH₃), or hexafluoroacetylacetone (HFAc, CF₃C(O)CH₂C(O)CF₃). In Step ST2, the development may be performed by a thermal reaction between the development gas and the metal-containing resist RM. Alternatively, the development may be performed by a chemical reaction between chemical species in the plasma generated from the development gas and the metal-containing resist RM.

In Step ST2, one or more of a plurality of development parameters may be changed. The plurality of development parameters include a temperature of the first substrate W1 or the substrate support 121, a pressure in the processing chamber 102, a flow rate of the development gas, a type of the development gas, and a residence time of the development gas with respect to the first substrate W1. One or more of these development parameters may be periodically changed. In an example, in Step ST2, after the temperature of the substrate support 121 is set to a first temperature (for example, 10°C or higher and 30°C or lower), the temperature may be changed to a second temperature (for example, 40°C or higher and 100°C or lower) higher than the first temperature.

Step ST2 may be executed until the etching target film FL is exposed. FIG. 7 is a view showing an example of a cross-sectional structure of the first substrate W1 after Step ST2. In the example shown in FIG. 7, the second region RM2 of the metal-containing resist RM is removed, and an opening OP is formed. The opening OP is defined by side surfaces of the first region RM1. The opening OP has a shape corresponding to the second region RM2 (consequently a shape corresponding to the exposure mask pattern used for the EUV exposure) in a plan view of the first substrate W1. The shape may be, for example, a circle, an ellipse, a rectangle, or a shape obtained by combining one or more of these. A plurality of openings OP may be formed in the metal-containing resist RM. Each opening OP may have a line pattern or a hole pattern.

### (Step ST3)

After Step ST2, in Step ST3, the first substrate W1 may be transported outside the processing chamber 102 from a transport port of the first substrate W1. Step ST3 may be included between Step ST2 and Step ST6. Since Step ST2 is performed in a state where the first substrate W1 is provided in the processing chamber 102, a first metal-containing substance MS1 can adhere to the surface of the first substrate W1. In Step ST3, the first substrate W1 to which the first metal-containing substance MS1 has adhered may be transported.

### (Step ST4)

In Step ST4, Step ST1, Step ST2, and Step ST3 may be repeated. Step ST4 may be included between Step ST2 and Step ST6. By Step ST4, the plurality of first substrates W1 may be sequentially subjected to dry development. Alternatively, in a case where the dry development is performed on one first substrate W1, Step ST4 may not be performed.

### (Step ST5)

After Step ST4, in Step ST5, as shown in FIG. 8, the second substrate W2 different from the first substrate W1 may be transported into the processing chamber 102. The second substrate W2 may be a cleaning substrate (dummy wafer). In Step ST1 and Step ST3 to Step ST5, for example, the substrate may be carried in and carried out by a transport robot.

By the dry development in Step ST2, the first metal-containing substance MS1 can adhere to the processing chamber 102 or the component disposed in the processing chamber 102, as shown in FIG. 8. FIG. 8 is a partially enlarged cross-sectional view of an example of the substrate processing apparatus after Step ST5. The first metal-containing substance MS1 can coat the inner surface of the processing chamber 102, and the surfaces of the ring assembly 125 and the substrate support 121. The first metal-containing substance MS1 can contain the same metal as the metal contained in the metal-containing resist RM. The first metal-containing substance MS1 may contain at least one selected from the group consisting of tin (Sn), hafnium (Hf), and titanium (Ti). The first metal-containing substance MS1 may contain at least one selected from the group consisting of tin oxide, hafnium oxide, and titanium oxide.

### (Step ST6)

In Step ST6, the first metal-containing substance MS1 adhered to the processing chamber 102, the ring assembly 125, and the substrate support 121 is removed. Step ST6 may be performed in a state in which the second substrate W2 is disposed on the substrate support 121. Step ST6 includes Step ST61 and Step ST62 after Step ST61.

### (Step ST61)

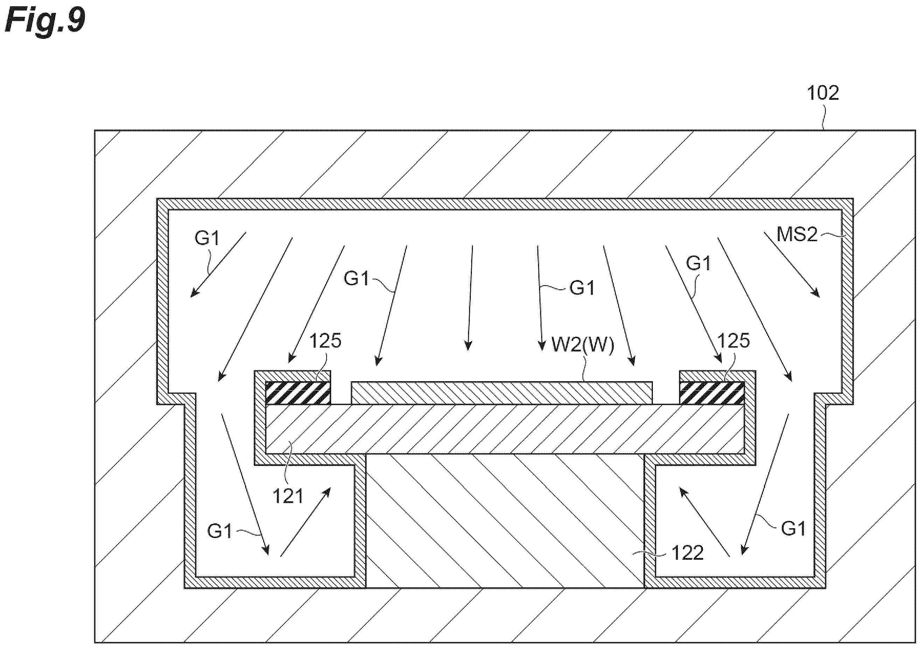

First, in Step ST61, as shown in FIG. 9, a second metal-containing substance MS2 is generated from the first metal-containing substance MS1 by using a fluorine-containing gas G1. FIG. 9 is a partially enlarged cross-sectional view of an example of a substrate processing apparatus in a step of generating the second metal-containing substance MS2. In Step ST61, the second metal-containing substance MS2 is generated from the first metal-containing substance MS1 adhered to the processing chamber 102, the ring assembly 125, and the substrate support 121, by using the fluorine-containing gas G1 in the processing chamber 102. The second metal-containing substance MS2 can coat the inner surface of the processing chamber 102, and the surfaces of the ring assembly 125 and the substrate support 121. The fluorine-containing gas G1 is supplied into the processing chamber 102 from the gas supply 170. The supply of the fluorine-containing gas G1 may be stopped at the end of Step ST61. In Step ST61, the second metal-containing substance MS2 may be generated by using the fluorine-containing gas G1 without generating plasma.

The fluorine-containing gas G1 may include at least one selected from the group consisting of a hydrogen fluoride gas (HF gas), a fluorocarbon gas, a hydrofluorocarbon gas, a nitrogen fluoride gas, and a sulfur fluoride gas. The fluorocarbon gas may include at least one selected from the group consisting of a C₄F₆ gas, a C₄F₈ gas, a C₃F₈ gas, and a CF₄ gas. The hydrofluorocarbon gas may include at least one selected from the group consisting of a CHF₃ gas and a CH₂F₂ gas. The nitrogen fluoride gas may include an NF₃ gas. The sulfur fluoride gas may include an SF₆ gas. The fluorine-containing gas G1 is supplied into the processing chamber 102 by the gas supply 170.

The second metal-containing substance MS2 can be generated by a reaction between the first metal-containing substance MS1 and the fluorine-containing gas G1. The second metal-containing substance MS2 may contain the same metal as the metal contained in the first metal-containing substance MS1, and fluorine. The second metal-containing substance MS2 may contain a metal fluoride. In an example, the second metal-containing substance MS2 may contain tin fluoride (SnF). The second metal-containing substance MS2 may contain at least one selected from the group consisting of SnF₄ and SnF₂.

After Step ST61, a purging step may be performed. In the purging step, after a purge gas is supplied into the processing chamber 102, the purge gas is exhausted. The purge gas is, for example, an inert gas such as nitrogen or argon.

### (Step ST62)

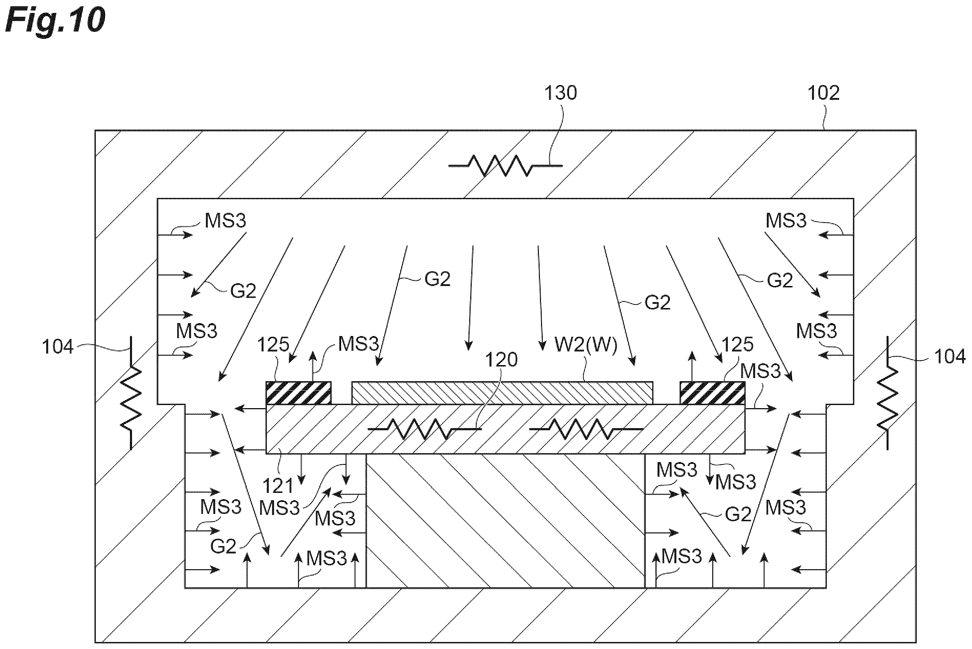

In Step ST62, as shown in FIG. 10, the processing chamber 102, the ring assembly 125, and the substrate support 121 are heated, and the processing gas G2 is supplied into the processing chamber 102. Accordingly, a third metal-containing substance MS3 is generated from the second metal-containing substance MS2, and the third metal-containing substance MS3 is removed. Therefore, the first metal-containing substance MS1 adhered to the processing chamber 102 or the component can be removed. FIG. 10 is a partially enlarged cross-sectional view of an example of a substrate processing apparatus in a step of forming and removing the third metal-containing substance MS3.

The processing gas G2 may include a chlorine-containing gas. The processing gas G2 may include at least one selected from the group consisting of a silicon tetrachloride gas (SiCl₄ gas), a titanium tetrachloride gas (TiCl₄ gas), a dimethylaluminum chloride gas (DMAC gas), a thionyl chloride gas (SOCl₂ gas), and an acetyl chloride gas (CH₃COCl gas). The processing gas G2 is supplied into the processing chamber 102 by the gas supply 170. The supply of the processing gas G2 may be stopped at the end of Step ST62.

The third metal-containing substance MS3 may contain tin chloride (SnCl). The third metal-containing substance MS3 may contain at least one selected from the group consisting of SnCl₃, SnCl₄, and SnFCl₃.

By controlling one or more outputs of the heater group, the processing chamber 102 or the component disposed in the processing chamber 102 may be heated. Alternatively, the processing chamber 102 or the component disposed in the processing chamber 102 may be heated by controlling the microwave heating device 50, or may be heated by simultaneously controlling at least one of the heater groups and the microwave heating device 50. The processing chamber 102 or the component disposed in the processing chamber 102 may be heated to 90°C or higher or may be heated to 120°C or higher, or may be heated to 90°C or higher and 300°C or lower.

The pressure in the processing chamber 102 in Step ST62 may be 100 mTorr (13 Pa) or more. In a case where the pressure is increased, the supply amount of the processing gas G2 can be increased. Therefore, the cleaning speed can be increased.

In Step ST62, the second metal-containing substance MS2 is modified by the processing gas G2, and thus a highly volatile third metal-containing substance MS3 is generated. For example, F of SnF can be exchanged with Cl by carrying out a ligand exchange reaction between the chlorine-containing gas and SnF. As a result, SnCl having high volatility may be generated. Heating promotes the generation of the third metal-containing substance MS3 from the second metal-containing substance MS2 and the volatilization (removal) of the third metal-containing substance MS3.

### (Step ST7)

In Step ST7, the second substrate W2 may be transported outside the processing chamber 102.

According to the method MT1 described above, it is possible to suppress the damage to the processing chamber 102 or the component due to cleaning, as compared with a case where the first metal-containing substance MS1 adhered to the processing chamber 102 or the component is removed by using plasma generated from chlorine gas.

The metal-containing resist RM and the first metal-containing substance MS1 can contain tin. The second metal-containing substance MS2 can contain tin fluoride. The processing gas G2 may include a chlorine-containing gas. The third metal-containing substance MS3 can contain tin chloride. In this case, the third metal-containing substance MS3 containing tin chloride is generated by a ligand exchange reaction between the second metal-containing substance MS2 containing tin fluoride and the chlorine-containing gas. The third metal-containing substance MS3 is removed by volatilization of the third metal-containing substance MS3.

In Step ST62, the processing chamber 102, the ring assembly 125, and the substrate support 121 may be heated to 90°C or higher or may be heated to 120°C or higher. In this case, a reaction in which the third metal-containing substance MS3 is generated from the second metal-containing substance MS2 can be promoted.

Step ST4 in which Step ST1 to Step ST3 are repeated may be included between Step ST2 and Step ST6. In this case, the throughput of Step ST2 can be improved as compared to a case where Step ST6 is performed each time Step ST2 is performed.

Step ST6 may be performed in a state where the second substrate W2 different from the first substrate W1 is disposed on the substrate support 121. In this case, Step ST6 can be performed while protecting the substrate support 121.

Although the various exemplary embodiments have been described above, various additions, omissions, substitutions, and changes may be made without being limited to the exemplary embodiments described above. In addition, other embodiments can be formed by combining elements in different embodiments.

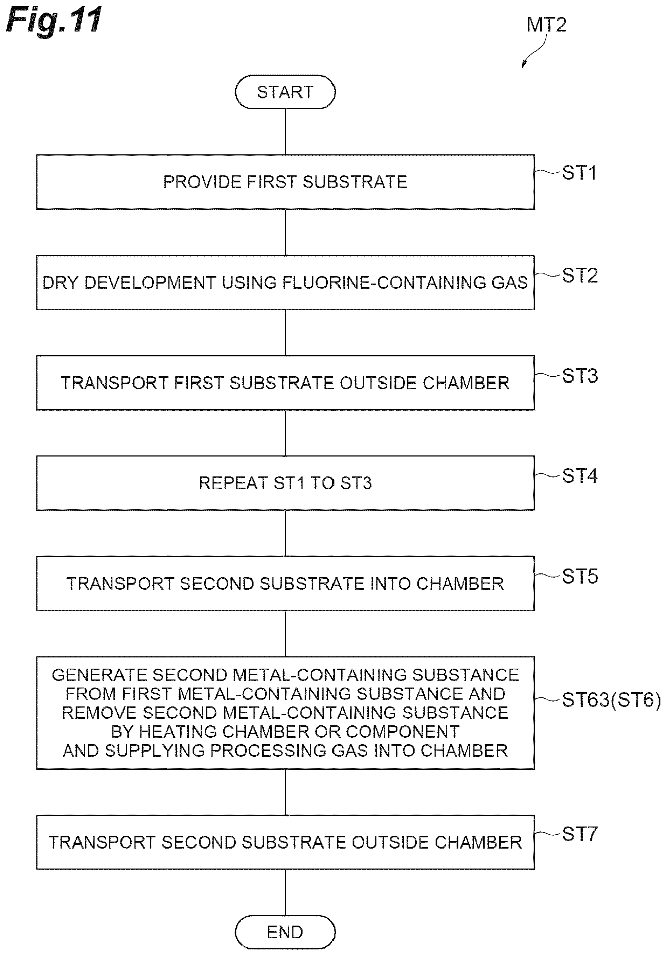

FIG. 11 is a flowchart of a substrate processing method (hereinafter, referred to as a "method MT2") according to a modification example. Differences between the method MT2 and the method MT1 will be described. In the method MT2, in Step ST2, dry development may be performed using a development gas including a fluorine-containing gas. In the method MT2, the first metal-containing substance MS1 may contain a metal fluoride. In the method MT2, as shown in FIG. 11, Step ST63 may be performed as Step ST6 after Step ST5. In Step ST63, the processing chamber 102 or the component may be heated, and the processing gas G2 may be supplied into the processing chamber 102 to generate the second metal-containing substance MS2 from the first metal-containing substance MS1 and the second metal-containing substance MS2 may be removed. In this case, for example, in Step ST2, by using a fluorine-containing gas as the development gas, the first metal-containing substance MS1 can contain tin fluoride (SnF). Therefore, the second metal-containing substance MS2 containing tin chloride is generated by a ligand exchange reaction between the first metal-containing substance MS1 containing tin fluoride and the chlorine-containing gas. The second metal-containing substance MS2 can be removed by volatilization of the second metal-containing substance MS2. In the method MT2, Step ST61 of the method MT1 can be omitted.

In the method MT1, a plasma processing apparatus 1 shown in FIGS. 3 and 4 may be used as a development processing system. In Step ST61, the second metal-containing substance MS2 may be generated by using the plasma generated from the fluorine-containing gas G1. In this case, by generating plasma from the fluorine-containing gas G1, for example, active species such as fluorine ions and fluorine radicals can be generated.

Here, the various exemplary embodiments included in the present disclosure are described in [E1] to [E13] below.
[E1] A substrate processing method including
   (a) providing a substrate on a substrate support in a chamber, the substrate including an etching target film and a metal-containing resist on the etching target film, the metal-containing resist including a first region exposed to EUV light and a second region not exposed to the EUV light,
   (b) removing the second region by dry development using a development gas, and
   (c) removing a first metal-containing substance adhered to the chamber or a component disposed in the chamber after the (b),
   in which the (c) includes
   (c1) generating a second metal-containing substance from the first metal-containing substance using a fluorine-containing gas, the second metal-containing substance including a metal fluoride, and
   (c2) generating a third metal-containing substance from the second metal-containing substance and removing the third metal-containing substance by heating the chamber or the component and supplying a processing gas into the chamber.
[E2] The substrate processing method according to [E1],
   in which the metal-containing resist and the first metal-containing substance include tin,
   the second metal-containing substance includes tin fluoride,
   the processing gas includes a chlorine-containing gas, and
   the third metal-containing substance includes tin chloride.
[E3] The substrate processing method according to [E1] or [E2], in which the fluorine-containing gas includes at least one selected from the group consisting of a hydrogen fluoride gas, a fluorocarbon gas, a hydrofluorocarbon gas, a nitrogen fluoride gas, and a sulfur fluoride gas.
[E4] The substrate processing method according to any one of [E1] to [E3], in which in the (c1), the second metal-containing substance is generated using plasma generated from the fluorine-containing gas.
[E5] The substrate processing method according to any one of [E1] to [E3], in which in the (c1), the second metal-containing substance is generated using a hydrogen fluoride gas without generating plasma.
[E6] The substrate processing method according to any one of [E2] or [E3] to [E5] citing [E2], in which the chlorine-containing gas includes at least one selected from the group consisting of a silicon tetrachloride gas, a titanium tetrachloride gas, a dimethylaluminum chloride gas, a thionyl chloride gas, and an acetyl chloride gas.
[E7] The substrate processing method according to any one of [E1] to [E6], in which in the (c2), the chamber or the component is heated to 90°C or higher.
[E8] The substrate processing method according to any one of [E1] to [E7], further including (d) repeating the (a) and the (b) between the (b) and the (c).
[E9] The substrate processing method according to any one of [E1] to [E8], further including (e) transporting the substrate outside the chamber between the (b) and the (c).
[E10] The substrate processing method according to [E9],
   in which the substrate is a first substrate, and
   the (c) is performed in a state where a second substrate different from the first substrate is disposed on the substrate support.
[E11] The substrate processing method according to any one of [E1] to [E10], in which the development gas includes at least one selected from the group consisting of a hydrogen bromide gas, a hydrogen fluoride gas, a hydrogen chloride gas, a boron trichloride gas, an organic acid gas, and a β-dicarbonyl compound gas.
[E12] A substrate processing method including
   (a) providing a substrate on a substrate support in a chamber, the substrate including an etching target film and a metal-containing resist on the etching target film, the metal-containing resist including a first region exposed to EUV light and a second region not exposed to the EUV light,
   (b) removing the second region by dry development using a development gas including a fluorine-containing gas, and
   (c) removing a first metal-containing substance adhered to the chamber or a component disposed in the chamber after the (b), the first metal-containing substance including a metal fluoride,
   in which the (c) includes generating a second metal-containing substance from the first metal-containing substance and removing the second metal-containing substance by heating the chamber or the component and supplying a processing gas into the chamber.
[E13] A substrate processing apparatus including
   a chamber,
   a substrate support configured to support a substrate in the chamber, in which the substrate includes an etching target film and a metal-containing resist on the etching target film, and the metal-containing resist has a first region exposed to EUV light and a second region not exposed to the EUV light,
   a gas supply configured to supply each of a development gas, a fluorine-containing gas, and a processing gas into the chamber, and
   a controller configured to control the gas supply to
   remove the second region by dry development using the development gas,
   remove a first metal-containing substance adhered to the chamber or a component disposed in the chamber after the second region is removed,
   in the removing of the first metal-containing substance,
   generate a second metal-containing substance from the first metal-containing substance using the fluorine-containing gas, the second metal-containing substance including a metal fluoride, and
   generate a third metal-containing substance from the second metal-containing substance and remove the third metal-containing substance by heating the chamber or the component and supplying the processing gas into the chamber.

### Reference Signs List

1, 100, 101: substrate processing apparatus
10, 102: chamber (processing chamber)
11, 121: substrate support
FL: etching target film
G1: fluorine-containing gas
G2: processing gas
MS1: first metal-containing substance
MS2: second metal-containing substance
MS3: third metal-containing substance
MT1: substrate processing method
RM: metal-containing resist
RM1: first region
RM2: second region
W: substrate

## Claims

1. A substrate processing method comprising:
(a) providing a substrate on a substrate support in a chamber, the substrate including an etching target film and a metal-containing resist on the etching target film, the metal-containing resist including a first region exposed to EUV light and a second region not exposed to the EUV light;
(b) removing the second region by dry development using a development gas; and
(c) removing a first metal-containing substance adhered to the chamber or a component disposed in the chamber after the (b),
wherein the (c) includes
(c1) generating a second metal-containing substance from the first metal-containing substance using a fluorine-containing gas, the second metal-containing substance including a metal fluoride, and
(c2) generating a third metal-containing substance from the second metal-containing substance and removing the third metal-containing substance by heating the chamber or the component and supplying a processing gas into the chamber.

2. The substrate processing method according to Claim 1,
wherein the metal-containing resist and the first metal-containing substance include tin,
the second metal-containing substance includes tin fluoride,
the processing gas includes a chlorine-containing gas, and
the third metal-containing substance includes tin chloride.

3. The substrate processing method according to Claim 1,
wherein the fluorine-containing gas includes at least one selected from the group consisting of a hydrogen fluoride gas, a fluorocarbon gas, a hydrofluorocarbon gas, a nitrogen fluoride gas, and a sulfur fluoride gas.

4. The substrate processing method according to Claim 1,
wherein in the (c1), the second metal-containing substance is generated using plasma generated from the fluorine-containing gas.

5. The substrate processing method according to Claim 1,
wherein in the (c1), the second metal-containing substance is generated using a hydrogen fluoride gas without generating plasma.

6. The substrate processing method according to Claim 2,
wherein the chlorine-containing gas includes at least one selected from the group consisting of a silicon tetrachloride gas, a titanium tetrachloride gas, a dimethylaluminum chloride gas, a thionyl chloride gas, and an acetyl chloride gas.

7. The substrate processing method according to Claim 1,
wherein in the (c2), the chamber or the component is heated to 90°C or higher.

8. The substrate processing method according to Claim 1, further comprising:
(d) repeating the (a) and the (b) between the (b) and the (c).

9. The substrate processing method according to Claim 1, further comprising:
(e) transporting the substrate outside the chamber between the (b) and the (c).

10. The substrate processing method according to Claim 9,
wherein the substrate is a first substrate, and
the (c) is performed in a state where a second substrate different from the first substrate is disposed on the substrate support.

11. The substrate processing method according to any one of Claims 1 to 10,
wherein the development gas includes at least one selected from the group consisting of a hydrogen bromide gas, a hydrogen fluoride gas, a hydrogen chloride gas, a boron trichloride gas, an organic acid gas, and a β-dicarbonyl compound gas.

12. A substrate processing method comprising:
(a) providing a substrate on a substrate support in a chamber, the substrate including an etching target film and a metal-containing resist on the etching target film, the metal-containing resist including a first region exposed to EUV light and a second region not exposed to the EUV light;
(b) removing the second region by dry development using a development gas including a fluorine-containing gas; and
(c) removing a first metal-containing substance adhered to the chamber or a component disposed in the chamber after the (b), the first metal-containing substance including a metal fluoride,
wherein the (c) includes generating a second metal-containing substance from the first metal-containing substance and removing the second metal-containing substance by heating the chamber or the component and supplying a processing gas into the chamber.

13. A substrate processing apparatus comprising:
a chamber;
a substrate support configured to support a substrate in the chamber, in which the substrate includes an etching target film and a metal-containing resist on the etching target film, and the metal-containing resist has a first region exposed to EUV light and a second region not exposed to the EUV light;
a gas supply configured to supply each of a development gas, a fluorine-containing gas, and a processing gas into the chamber; and
a controller configured to control the gas supply to:
remove the second region by dry development using the development gas;
remove a first metal-containing substance adhered to the chamber or a component disposed in the chamber after the second region is removed;
in the removing of the first metal-containing substance,
generate a second metal-containing substance from the first metal-containing substance using the fluorine-containing gas, the second metal-containing substance including a metal fluoride; and
generate a third metal-containing substance from the second metal-containing substance and remove the third metal-containing substance by heating the chamber or the component and supplying the processing gas into the chamber.
